# EUROPEAN PATENT APPLICATION

(11) **EP 2 940 786 A1**
(43) Date of publication of application: **04.11.2015**
(21) Application number: 13869042.5
(22) Date of filing: 23.08.2013
(51) Int. Cl.: H01Q 1/22

(54) **LAND GRID ARRAY MODULE AND DEVICE**

(30) Priority: 28.12.2012 CN 201210583439
(71) Applicant: ZTE Corporation, Shenzhen, Guangdong 518057 (CN)
(72) Inventor: HE, Xiangyu, Shenzhen Guangdong 518057 (CN); SUN, Weiju, Shenzhen Guangdong 518057 (CN); MA, Hairong, Shenzhen Guangdong 518057 (CN)
(74) Representative: Mozzi, Matteo
(86) International application number: PCT/CN2013/082217
(87) International publication number: WO 2014/101446

(57) **Abstract**

In order to solve the problem that connections between a module body and one or more antennas are unstable in an existing LGA module, provided are a Land Grid Array (LGA) module and a device. The LGA module comprises a module body and one or more antennas, wherein the module body and the one or more antennas are of an integrated structure. By the implementation of the present invention, the module body and the one or more antennas in the LGA module are integrated, so that the strength of connections between the module body and the one or more antennas are enhanced, a phenomenon that the module body is separated from the one or more antennas is avoided during use, and the stable running of the device is ensured.

## Description

### Technical Field

The present invention relates to the communication devices manufacturing field, and in particular to a Land Grid Array (LGA) module and a device.

### Background

With the increasing demanding on a 3G function of a terminal user, an encapsulated component, represented by a LGA technology, is favoured by more and more terminal device manufacturers due to its stable structure characteristics and excellent environmental adaptability.

In the existing LGA module, a main way for connecting a module body with one or more antennas is to connect the one or more antennas to a Radio Frequency (RF) test socket of the module body through an RF connecting line. However, this connecting way has obvious defects that the connecting way is unstable and one or more seams of the connecting way is easy to get loose, so that the reliability of this communication connection is relatively low.

### Summary

In order to solve the problem that connections between a module body and one or more antennas are unstable in an existing LGA module, the embodiments of the present invention provides a LGA module and a device.

In an example embodiment, one embodiment of the present invention provides a LGA module, which includes a module body and one or more antennas, wherein the module body and the one or more antennas are of an integrated structure.

In an example embodiment, one end of the module body extends outwards to form an extension part where the one or more antennas are located.

In an example embodiment, the extension part is formed by extending an RF area of the module body.

In an example embodiment, the one or more antennas are located in the extension part of the module body in a routing form.

In an example embodiment, the extension part is a flexible circuit board.

In an example embodiment, the flexible circuit board includes at least two board layers which are used for grounding, and an RF signal layer which is located between two adjacent board layers; and the one or more antennas are located in the RF signal layer in a routing form.

In an example embodiment, the medium thicknesses between the RF signal layer and the two adjacent board layers are determined according to a 50ohm impedance control principle and the running width of the one or more antennas.

In an example embodiment, in the embodiment, the module body is a Printed Circuit Board (PCB), and the flexible circuit board is formed by extending the top three layers of the PCB.

In an example embodiment, medium thicknesses between the RF signal layer and the two adjacent board layers are determined according to a 50ohm impedance control principle and the routing width of the one or more antennas.

In an example embodiment, the one or more antennas are one or more of the followings: an RF antenna, a Bluetooth antenna and a Global Position System (GPS) antenna.

Another embodiment of the present invention further provides a device, which includes a main board and the LGA module provided by any one of the embodiments above, and the LAG module is connected with the main board.

In an example embodiment, one end of the module body of the LGA module extends outwards to form an extension part which is connected with the main board in a detachable connection way; and the other end of the module body is connected with the main board in a non-detachable way.

In the embodiments of the present invention, the module body and the one or more antennas in the LGA module are integrated, so that the strength of connections between the module body and the one or more antennas is enhanced, a phenomenon that the module body is separated from the one or more antennas is avoided during use, and the stable running of the device is ensured; and in an example embodiment, the extension part where the one or more antennas are located is set to the flexible circuit board and can be placed in any idle position of the main board of the device when the one or more antennas are installed to a terminal device, so that the selectivity of position for placing the one or more antennas is increased during a installation process of the device.

### Brief Description of the Drawings

Fig. 1 is a schematic diagram showing a LGA module according to an embodiment of the present invention;
Fig. 2 is a schematic diagram showing a LGA module according to another embodiment of the present invention;
Fig. 3 is a schematic diagram showing an extension part in Fig. 2; and
Fig. 4 is a schematic diagram showing a device according to an embodiment of the present invention.

### Detailed Description of Embodiments

The present invention is described below in combination with specific embodiments and drawings.

An embodiment of the present invention provides a LGA module and a device, in order to solve the problem that a connection between a module body and one or more antennas are unstable since the module body is separated from the one or more antennas in the existing LGA module.

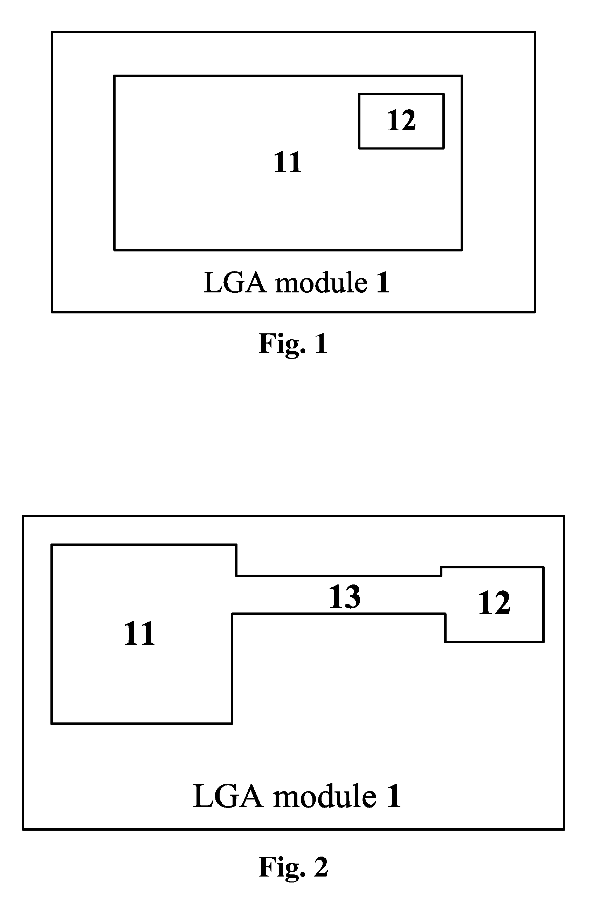

Fig. 1 is a diagram showing a LGA module according to an embodiment of the present invention; as shown in Fig. 1, in this embodiment, the LGA module 1 includes a module body 11 and one or more antennas 12, wherein
the module body 11 is configured to implement a basic data processing function of the LGA module; and
the one or more antennas 12 are configured to send and receive a signal between the module body 11 and one or more external devices.

In this embodiment, the module body 11 and the one or more antennas 12 are of an integrated structure; and specifically, they can be located in a same base board.

Fig. 2 is a schematic diagram showing a LGA module according to another embodiment of the present invention; as shown in Fig. 2, in this embodiment, the LGA module 1 includes a module body 11 and one or more antennas 12, wherein one end of the module body 11 extends outwards to form an extension part 13 where the one or more antennas 12 are located; and the extension part 13 can be of various shapes, such as rectangle, circular arc and other regular or irregular shapes, and is not limited to the shape as shown in Fig. 2.

In an example embodiment, the extension part 13 is formed by extending an RF area of the module body 11; and the RF area refers to an area implementing a RF communication function of the LGA module 1.

In an example embodiment, the one or more antennas 12 are located in the extension part 13 of the module body 11 in a routing form.

In an example embodiment, the extension part 13 is a flexible circuit board which is a Flexible Printed Circuit (FPC) board. Of course, the extension part 13 can also be a circuit board of other types only if the extension part has a route and curve which can be used for transmitting a signal.

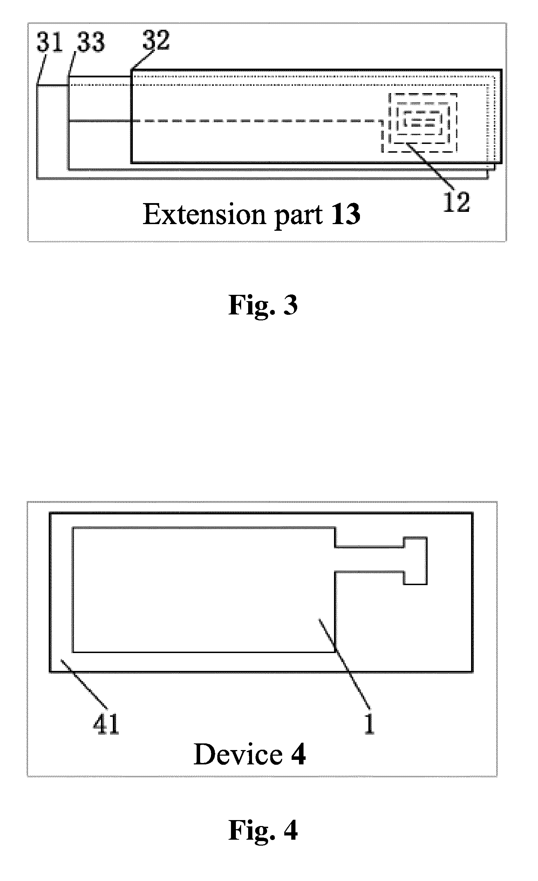

Fig. 3 is a schematic diagram showing an extension part 13 in Fig. 2; as shown in Fig. 3, in this embodiment, the extension part 13 is an FPC board which includes at least two board layers 31 and 32 which are used for grounding, and an RF signal layer 33 between two adjacent board layers, wherein one or more antennas 12 are located in the RF signal layer 33 in a routing form; and the routing of the one or more antennas 12 can be in various forms, and Fig. 3 only shows the best routing way and is not intended to limit the present invention.

In an example embodiment, medium thicknesses between the RF signal layer 33 and the board layers 31 and 32 are determined according to a 50ohm impedance control principle and the routing width of the one or more antennas 12.

In an example embodiment, the module body is a PCB, and the FPC board is formed by extending the top three layers of the PCB; the top three layers here refer to a first layer, a second layer and a third layer of the PCB used by the module body in the LGA module , namely, the first layer of the PCB extends to form the board layer 31, the second layer of the PCB extends to form the RF signal layer 33 and the third layer of the PCB extends to form the board layer 32.

In an example embodiment, the one or more antennas are one or more of near field communication antennas, such as an RF antenna, a Bluetooth antenna, a GPS antenna.

Fig. 4 is a schematic diagram showing a device according to an embodiment of the present invention; as shown in Fig. 4, in this embodiment, the device 4 includes a main board 41 and the LGA module 1 provided by any one of the embodiments above, wherein the LGA module 1 includes a module body 11 and an extension part 13, and the LGA module 1 is connected with the main board 41.

In an example embodiment, one end of the module body 11 of the LGA module 1 extends outwards to form the extension part 13 which is connected with the main board 41 in a detachable connection way; and the other end of the module body 11 is connected with the main board 41 in a non-detachable connection way. Specifically, the extension part 13 can be connected with the main board 41 by a double side tape or in other ways, and the other end of the module body 11 is connected with the main board 41 by welding; thus, detachment can be avoided between the LGA module 1 and the main board 41, and furthermore, the one or more antennas 13 can be placed in an idle position of the main board 41 casually and can be moved conveniently to facilitate the layout of respective components in the device 4; and when the LGA module 1 and/or the main board 41 have/has a plurality of antennas, signal interference between respective antenna needs to be considered during the layout, so that the one or more antennas need to be isolated.

The embodiments of the present invention at least have the following advantages:
1, the module body and the one or more antennas in the LGA module are integrated, so that the strength of connections between the module body and the one or more antennas is enhanced, the phenomenon that the module body is separated from the one or more antennas is avoided during use, and the stable running of the device is ensured;
2, the extension part where the one or more antennas are located is set to the flexible circuit board and can be placed in any idle position of the main board of the device when the one or more antennas are installed to the device, so that the selectivity of position for placing the one or more antennas is increased during a installation process of the device; and
3, medium thicknesses between the RF signal layer 33 and the board layers 31 and 32 are determined according to a 50ohm impedance control principle and the routing width of the one or more antennas 12, so that the attenuation of the RF signal in the transmission process is reduced.

### Industrial Applicability

By the technical solution provided by the embodiments of the present invention, a module body and one or more antennas are integrated, so that a manufacturing process is simple, a structure is firm and an excellent industrial applicability is implemented.

What said above are only the specific embodiments of the present invention and not intended to limit the present invention in any form. Any simple change, equivalent variations or modification made for the embodiments above according to the technical essence of the present invention shall fall within the protection scope of the technical solution of the present invention.

## Claims

1. A Land Grid Array, LGA, module, **characterized by** comprising a module body and one or more antennas, wherein the module body and the one or more antennas are of an integrated structure.

2. The LGA module according to claim 1, **characterized in that** one end of the module body extends outwards to form an extension part where the one or more antennas are located.

3. The LGA module according to claim 2, **characterized in that** the extension part is formed by extending a Radio Frequency, RF, area of the module body.

4. The LGA module according to claim 2, **characterized in that** the one or more antennas are located in the extension part of the module body in a routing form.

5. The LGA module according to claim 2, **characterized in that** the extension part is a flexible circuit board.

6. The LGA module according to claim 5, **characterized in that** the flexible circuit board comprises at least two board layers which are used for grounding, and an RF signal layer which is located between two adjacent board layers; and the one or more antennas are located in the RF signal layer in a routing form.

7. The LGA module according to claim 6, **characterized in that** the module body is a Printed Circuit Board, PCB, and the flexible circuit board is formed by extending top three layers of the PCB.

8. The LGA module according to claim 5, **characterized in that** medium thicknesses between the RF signal layer and the two adjacent board layers are determined according to a 50ohm impedance control principle and the routing width of the one or more antennas.

9. The LGA module according to any one of claims 1 to 8, **characterized in that** the one or more antennas are one or more of the followings: an RF antenna, a Bluetooth antenna, a Global Position System, GPS, antenna.

10. A device, **characterized by** comprising a main board and the LGA module in any one of the claims 1 to 9, **characterized in that** the LGA module is connected with the main board.

11. The device according to claim 10, **characterized in that** one end of the module body of the LGA module extends outwards to form an extension part which is connected with the main board in a detachable connection way; and the other end of the module body is connected with the main board in a non-detachable way.
